(19) Europäisches Patentamt
European Patent Office
Office européen des brevets

(11) **EP 3 678 457 B1**

(12) **EUROPÄISCHE PATENTSCHRIFT**

(45) Veröffentlichungstag und Bekanntmachung des Hinweises auf die Patenterteilung:
**28.04.2021 Patentblatt 2021/17**

(51) Int Cl.:
*H05F 3/02* *(2006.01)*

(21) Anmeldenummer: **19216402.8**

(22) Anmeldetag: **16.12.2019**

(54) **ANORDNUNG UND VERFAHREN ZUM VERBINDEN VON KONTAKTSTELLEN MIT EINEM BEZUGSPOTENTIAL**

ARRANGEMENT AND METHOD FOR CONNECTING CONTACT POINTS TO A REFERENCE POTENTIAL

DISPOSITIF ET PROCÉDÉ DE RACCORDEMENT DES POINTS DE CONTACT À UN POTENTIEL DE RÉFÉRENCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.01.2019 DE 102019200095**

(43) Veröffentlichungstag der Anmeldung:
**08.07.2020 Patentblatt 2020/28**

(73) Patentinhaber: **Siemens Energy Global GmbH & Co. KG**
**81739 München (DE)**

(72) Erfinder: **Zahner, Ulrich**
**91052 Erlangen (DE)**

(56) Entgegenhaltungen:
DE-B4-112007 002 875       DE-C- 207 000
GB-A- 190 603 541         US-A1- 2005 155 782

• **"Low-voltage electrical installations - Part 4-41: Protection for safety - Protection against electric shock", IEC 60364-4-41:2005, IEC, 3, RUE DE VAREMBÉ, PO BOX 131, CH-1211 GENEVA 20, SWITZERLAND, 15. Dezember 2005 (2005-12-15), Seiten 1-32, XP082010308, [gefunden am 2005-12-15]**

**Beschreibung**

Die Erfindung bezieht sich auf eine Anordnung mit einer elektrischen Einrichtung, die mindestens zwei elektrische Kontaktstellen aufweist, und einer fluidbasierten Bezugspotentialverbindungseinrichtung, die geeignet ist, die elektrischen Kontaktstellen mit einem Bezugspotential zu verbinden. Eine solche Anordnung ist aus der deutschen Patentschrift DE 11 2007 002 875 B4 bekannt.

Der Erfindung liegt die Aufgabe zugrunde, eine Anordnung der vorbekannten Art besonders sicher auszugestalten.

Diese Aufgabe wird erfindungsgemäß durch eine Anordnung mit den Merkmalen gemäß Patentanspruch 1 gelöst. Vorteilhafte Ausgestaltungen der erfindungsgemäßen Anordnung sind in Unteransprüchen angegeben.

Danach ist erfindungsgemäß vorgesehen, dass die fluidbasierte Bezugspotentialverbindungseinrichtung eine ringförmige Fluidleitung aufweist, die die Kontaktstellen in Reihe verbindet, und im Falle eines Fluidstromes durch die Fluidleitung das Fluid die Kontaktstellen ausgehend von einer Ausgangsstelle Kontaktstelle für Kontaktstelle entlang einer vorgegebenen Fließrichtung nacheinander benetzt.

Ein wesentlicher Vorteil der erfindungsgemäßen Anordnung ist darin zu sehen, dass die Fluidleitung ringförmig ausgestaltet ist und die Kontaktstellen in Reihe verbunden sind, so dass die Kontaktstellen nacheinander benetzt werden und sich beispielsweise durch Überwachen der in der Fluidleitung fließenden elektrischen Ströme ein zuverlässiges Verbinden aller Kontaktstellen der elektrischen Einrichtung mit dem Bezugspotential, zum Beispiel Erde, zuverlässig überprüfen und überwachen lässt.

Die Bezugspotentialverbindungseinrichtung weist vorzugsweise eine Injektionseinrichtung auf, die an einer Injektionsstelle an die Fluidleitung angeschlossen und geeignet ist, leitfähiges Fluid an der Injektionsstelle in die Fluidleitung einzuspeisen und/oder die Leitfähigkeit eines in der Fluidleitung befindlichen Fluids durch Einspeisen einer die Leitfähigkeit erhöhenden Substanz zu erhöhen.

Die elektrische Einrichtung weist bei zumindest einer der Kontaktstellen vorzugsweise einen Vorwiderstand und/oder ein lichtemittierendes Element auf, der oder das bei einem Stromfluss über die Kontaktstellen von dem Strom durchflossen wird.

Die elektrische Einrichtung umfasst vorzugsweise bei zumindest einer der Kontaktstellen eine Bypassschaltung, die bei einem Stromfluss über die Kontaktstelle eine leitende Verbindung zu einer anderen Kontaktstelle, insbesondere der örtlich und/oder potentialmäßig nächstliegenden Kontaktstelle, herstellt. Die Bypassschaltung weist vorzugsweise zumindest ein Relais auf.

Die Fluidleitung weist in Fluidstromrichtung hinter der Injektionsstelle und vor der ersten Kontaktstelle vorzugsweise einen Messabschnitt auf, dessen elektrische Leitfähigkeit überwacht wird.

Auch ist es vorteilhaft, wenn an die Fluidleitung an einer Anschlussstelle, die in Fluidstromrichtung hinter der Injektionsstelle und vor der ersten Kontaktstelle liegt, eine Strommesseinrichtung (nachfolgend auch erste Strommesseinrichtung genannt) angeschlossen ist, die mit einem ersten Messanschluss an die Anschlussstelle angeschlossen ist und mit einem zweiten Messanschluss auf Bezugspotential liegt, und an einer Anregestelle, die zwischen der Injektionsstelle und der Anschlussstelle der Strommesseinrichtung liegt, eine Strom- oder Spannungsquelle angeschlossen ist, die einen Stromfluss zwischen Anregestelle und Anschlussstelle hervorruft, sobald der Leitungsabschnitt der Fluidleitung zwischen der Anregestelle und Anschlussstelle mit leitfähigem Fluid gefüllt ist.

An die Strommesseinrichtung ist vorzugsweise eine Steuereinrichtung angeschlossen, die die Strommesswerte der Strommesseinrichtung überwacht und die Injektionseinrichtung ansteuert.

Darüber hinaus wird es als vorteilhaft angesehen, wenn an die Fluidleitung an einer weiteren Anschlussstelle, die in Fluidstromrichtung hinter der letzten Kontaktstelle und vor der Injektionsstelle liegt, eine weitere Strommesseinrichtung (nachfolgend auch zweite Strommesseinrichtung genannt) angeschlossen ist, die mit einem ersten Messanschluss an die weitere Anschlussstelle angeschlossen ist und mit einem zweiten Messanschluss auf Bezugspotential liegt, und die weitere Strommesseinrichtung einen weiteren Stromanstieg, der nach Einspeisen leitfähigen Fluids und/oder Einspeisen einer die Leitfähigkeit erhöhenden Substanz und nach Erreichen der weiteren Anschlussstelle durch das leitfähige Fluid auftritt, erfasst.

Die Steuereinrichtung ist vorzugsweise mit der weiteren Strommesseinrichtung verbunden und schließt vorzugsweise anhand des erfassten weiteren Stromanstiegs darauf, dass die Fluidleitung bis einschließlich der weiteren Anschlussstelle und damit bis einschließlich der letzten Kontaktstelle mit leitfähigen Fluid gefüllt ist.

Im Übrigen ist es vorteilhaft, wenn zwischen der weiteren Anschlussstelle und Bezugspotential eine Schalteinrichtung angeordnet ist, die einen Stromfluss zwischen der weiteren Anschlussstelle und dem Bezugspotential unterbrechen kann.

Die Steuereinrichtung schaltet vorzugsweise nach Abschluss des Ausgleichs- bzw. Erdungsvorganges und/oder nach Absinken des durch die erste und/oder zweite Strommesseinrichtung fließenden Stromes die Schalteinrichtung ab und unterbindet somit einen Stromfluss durch die zweite Strommesseinrichtung zum Bezugspotential.

Die Steuereinrichtung ist vorzugsweise derart ausgestaltet, dass sie den Strommesswert der ersten Strommesseinrichtung vor dem Erreichen der ersten Kontaktstelle durch das Fluid mit dem Strommesswert nach Abschalten der Schalteinrichtung vergleicht und auf einen geschlossenen leitfähigen Fluidkreislauf schließt, wenn der Strommesswert vor dem Erreichen der ersten Kontaktstelle durch das Fluid kleiner als der Strommesswert nach Abschalten der Schalteinrichtung ist.

Die Bezugspotentialverbindungseinrichtung umfasst vorzugsweise ein Ablassventil, das ein Ablassen des in der Fluidleitung befindlichen Fluids ermöglicht.

Das Bezugspotential ist vorzugsweise das Erdpotential; die Bezugspotentialverbindungseinrichtung bildet somit vorzugsweise eine Erdungseinrichtung.

Die Erfindung bezieht sich darüber hinaus auf ein Verfahren zum Verbinden einer elektrischen Einrichtung, die mindestens zwei elektrische Kontaktstellen aufweist, mit einem Bezugspotential mittels einer fluidbasierten Bezugspotentialverbindungseinrichtung.

Erfindungsgemäß ist bezüglich eines solchen Verfahrens vorgesehen, dass die fluidbasierte Bezugspotentialverbindungseinrichtung eine ringförmige Fluidleitung aufweist, die die Kontaktstellen in Reihe verbindet, und die ringförmige Fluidleitung unter Bildung eines leitfähigen Fluidrings mit leitfähigem Fluid gefüllt und/oder die Leitfähigkeit eines in der Fluidleitung befindlichen Fluids durch Einspeisen einer die Leitfähigkeit erhöhenden Substanz erhöht wird und die Kontaktstellen nacheinander mit dem leitfähigem Fluid benetzt und dadurch nacheinander elektrisch miteinander verbunden werden.

Bezüglich der Vorteile des erfindungsgemäßen Verfahrens sei auf die obigen Erläuterungen im Zusammenhang mit der erfindungsgemäßen Anordnung verwiesen.

Als vorteilhaft wird es angesehen, wenn die elektrische Einrichtung bei zumindest einer der Kontaktstellen einen Vorwiderstand und/oder ein lichtemittierendes Element aufweist und der Stromfluss über die Kontaktstelle in das leitfähige Fluid durch den Vorwiderstand und/oder das lichtemittierende Element begrenzt wird.

Alternativ oder zusätzlich kann in vorteilhafter Weise vorgesehen sein, dass die elektrische Einrichtung bei zumindest einer der Kontaktstellen eine Bypassschaltung aufweist, die bei einem Stromfluss über die Kontaktstelle eine leitende Verbindung zu einer anderen Kontaktstelle, insbesondere der örtlich und/oder potentialmäßig nächstliegenden Kontaktstelle, herstellt und eine unmittelbare Entladung zwischen den miteinander verbundenen Kontaktstellen durchgeführt wird.

Alternativ oder zusätzlich kann in vorteilhafter Weise vorgesehen sein, dass die Fluidleitung in Fluidstromrichtung hinter der Injektionsstelle und - in Fließrichtung gesehen - vor der ersten Kontaktstelle einen Messabschnitt aufweist und die elektrische Leitfähigkeit des Messabschnitts überwacht wird.

Alternativ oder zusätzlich kann in vorteilhafter Weise vorgesehen sein, dass an die Fluidleitung an einer Anschlussstelle, die in Fluidstromrichtung hinter der Injektionsstelle und vor der ersten Kontaktstelle liegt, an die Fluidleitung eine Strommesseinrichtung angeschlossen ist, die mit einem ersten Messanschluss an die Anschlussstelle angeschlossen ist und mit einem zweiten Messanschluss auf Bezugspotential liegt, und an einer Anregestelle, die zwischen der Injektionsstelle und der Anschlussstelle der Strommesseinrichtung liegt, eine Strom- oder Spannungsquelle angeschlossen ist, die einen Stromfluss zwischen Anregestelle und Anschlussstelle hervorruft, sobald der Leitungsabschnitt der Fluidleitung zwischen der Anregestelle und Anschlussstelle mit leitfähigem Fluid gefüllt ist, die Strommesswerte der Strommesseinrichtung überwacht werden und die Injektionseinrichtung anhand der Strommesswerte angesteuert wird.

Alternativ oder zusätzlich kann in vorteilhafter Weise vorgesehen sein, dass mit der Strommesseinrichtung ein Stromanstieg, der nach Einspeisen leitfähigen Fluids und/oder Einspeisen einer die Leitfähigkeit erhöhenden Substanz und nach Erreichen der ersten Kontaktstelle durch das leitfähige Fluid auftritt, erfasst wird und anhand des Stromanstiegs darauf geschlossen wird, dass die Fluidleitung bis zur ersten Anschlussstelle mit leitfähigem Fluid gefüllt ist.

Alternativ oder zusätzlich kann in vorteilhafter Weise vorgesehen sein, dass mit der Strommesseinrichtung ein weiterer Stromanstieg, der nach Erreichen der ersten Kontaktstelle durch das leitfähige Fluid auftritt, erfasst wird und anhand des weiteren Stromanstiegs darauf geschlossen wird, dass die Fluidleitung bis zu der ersten Kontaktstelle mit dem leitfähigen Fluid gefüllt ist.

Alternativ oder zusätzlich kann in vorteilhafter Weise vorgesehen sein, dass an die Fluidleitung an einer weiteren Anschlussstelle, die in Fluidstromrichtung hinter der letzten Kontaktstelle und vor der Injektionsstelle liegt, eine weitere Strommesseinrichtung angeschlossen ist, die mit einem ersten Messanschluss an die weitere Anschlussstelle angeschlossen ist und mit einem zweiten Messanschluss auf Bezugspotential liegt, und die weiteren Strommesswerte der weiteren Strommesseinrichtung überwacht werden.

Alternativ oder zusätzlich kann in vorteilhafter Weise vorgesehen sein, dass ein von der weiteren Strommesseinrichtung gemessener Stromanstieg, der nach Einspeisen des leitfähigen Fluid und/oder Einspeisen der die Leitfähigkeit erhöhenden Substanz und Erreichen der weiteren Anschlussstelle durch das leitfähige Fluid auftritt, erfasst wird und anhand dieses Stromanstiegs darauf geschlossen wird, dass die Fluidleitung bis einschließlich der letzten Kontaktsstelle sowie der weiteren Anschlussstelle mit leitfähigen Fluid gefüllt ist.

Alternativ oder zusätzlich kann in vorteilhafter Weise vorgesehen sein, dass zwischen der weiteren Anschlussstelle und Bezugspotential eine Schalteinrichtung angeordnet ist, die einen Stromfluss zwischen der weiteren Anschlussstelle und Bezugspotential unterbrechen kann, und nach Abschluss des Erdungsvorganges oder nach Absinken des durch die erste und/oder zweite Strommesseinrichtung fließenden Stromes die Schalteinrichtung abgeschaltet wird und ein Stromfluss durch die zweite Strommesseinrichtung zum Bezugspotential unterbunden wird.

Alternativ oder zusätzlich kann in vorteilhafter Weise vorgesehen sein, dass der Strommesswert der ersten Strommesseinrichtung vor dem Erreichen der ersten Kontaktstelle durch das Fluid mit dem Strommesswert der ersten Strommesseinrichtung nach Abschalten der Schalteinrichtung verglichen wird und auf einen geschlossenen leitfähigen Fluidkreislauf geschlossen wird, wenn der Strommesswert der ersten Strommesseinrichtung vor dem Erreichen der ersten Kontaktstelle durch das Fluid kleiner als der Strommesswert der ersten Strommesseinrichtung nach Abschalten der Schalteinrichtung ist.

Die Erfindung wird nachfolgend anhand von Ausführungsbeispielen näher erläutert; dabei zeigen beispielhaft

Figur 1      ein Ausführungsbeispiel für eine erfindungsgemäße Anordnung, anhand derer ein Ausführungsbeispiel für das erfindungsgemäße Verfahren erläutert wird,

Figur 2      ein zweites Ausführungsbeispiel für eine erfindungsgemäße Anordnung, bei der zur Strombegrenzung Widerstände vorhanden sind,

Figur 3      ein drittes Ausführungsbeispiel für eine erfindungsgemäße Anordnung, bei der zwischen zwei Kontaktstellen der elektrischen Einrichtung ein Relais vorhanden ist, das eine leitende Verbindung unmittelbar zwischen den zwei Kontaktstellen herstellen kann,

Figur 4      ein viertes Ausführungsbeispiel für eine erfindungsgemäße Anordnung, bei der zwischen Kontaktstellen der elektrischen Einrichtung ein Relais vorhanden ist und Widerstände zur Strombegrenzung vorgesehen sind,

Figur 5      ein fünftes Ausführungsbeispiel für eine erfindungsgemäße Anordnung, bei der eine Schalteinrichtung zum Deaktivieren der weiteren Strommesseinrichtung vorgesehen ist,

Figur 6      ein sechstes Ausführungsbeispiel für eine erfindungsgemäße Anordnung, bei der die in den Figuren 1 bis 5 gezeigte weitere Strommesseinrichtung fehlt,

Figur 7      beispielhaft den Stromverlauf bei der Anordnung gemäß Figur 1 und

Figur 8      beispielhaft den Stromverlauf bei dem Ausführungsbeispiel gemäß Figur 6.

In den Figuren werden der Übersicht halber für identische oder vergleichbare Komponenten stets dieselben Bezugszeichen verwendet.

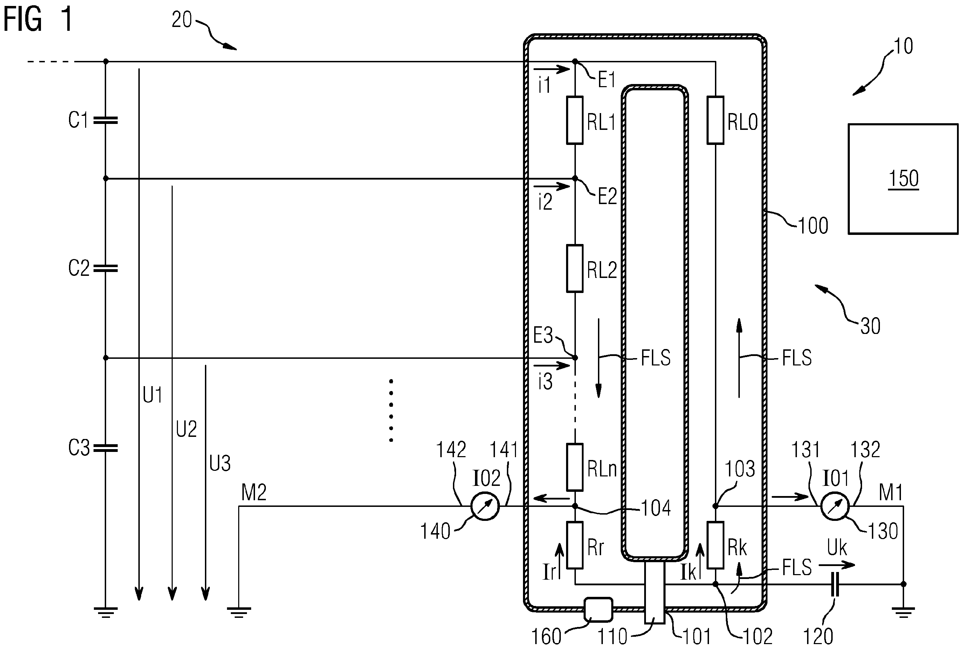

Die Figur 1 zeigt eine Anordnung mit einer elektrischen Einrichtung 20, die eine Vielzahl an elektrischen Kontaktstellen aufweist, von denen beispielhaft in der Figur 1 drei gezeigt und mit den Bezugszeichen E1, E2 und E3 gekennzeichnet sind. Die drei Kontaktstellen E1, E2 und E3 befinden sich auf unterschiedlichen elektrischen Potentialen und weisen demgemäß unterschiedliche elektrische Spannungen U1, U2 und U3 gegenüber einem Bezugspotential auf. Bei dem Bezugspotential handelt es sich beispielsweise um das Erdpotential. Elektrische Kondensatoren C1, C2 und C3 sind bei dem Ausführungsbeispiel gemäß Figur 1 geladen und gewährleisten die Potentialunterschiede zwischen den Kontaktstellen E1, E2 und E3.

Zum Entladen der Kondensatoren C1, C2 und C3 und zum Erden der Kontaktstellen E1, E2 und E3, weist die Anordnung 10 eine Bezugspotentialverbindungseinrichtung, hier als Erdungseinrichtung 30 ausgeführt, auf. Die Erdungseinrichtung 30 umfasst eine Fluidleitung 100, die mit einem leitfähigen Fluid gefüllt werden kann.

Zum Füllen der Fluidleitung 100 mit dem leitfähigen Fluid ist an einer Ausgangsstelle 101 der Fluidleitung 100 eine Injektionseinrichtung 110 angeschlossen, die leitfähiges Fluid an der Ausgangsstelle 101 in die Fluidleitung 100 einspeisen und/oder die Leitfähigkeit eines bereits in der Fluidleitung 100 befindlichen Fluids durch Einspeisen einer die Leitfähigkeit erhöhenden Substanz erhöhen kann. Die Ausgangsstelle 101 der Fluidleitung 100 bildet somit eine Injektionsstelle der Injektionseinrichtung 110.

Nachfolgend wird beispielhaft davon ausgegangen, dass die Injektionseinrichtung 110 nach Inbetriebnahme ein leitfähiges Fluid an der Ausgangsstelle 101 in die Fluidleitung 100 einspeist und das eingespeiste Fluid entlang der in der Figur 1 dargestellten Fluidstromrichtung FLS durch die Fluidleitung 100 fließt. Die Fluidstromrichtung FLS ist bei dem Ausführungsbeispiel gemäß Figur 1 also entgegen dem Uhrzeigersinn.

In Fluidstromrichtung FLS gesehen hinter der Injektionsstelle bzw. hinter der Ausgangsstelle 101 befindet sich eine Anregestelle 102, an der eine Spannungsquelle 120 angeschlossen ist. Die Spannungsquelle 120 erzeugt eine Messspannung Uk zwischen der Anregestelle 102 und dem Erdpotential.

An einer in Fluidstromrichtung FLS dahinter befindlichen Anschlussstelle 103 der Fluidleitung 100 ist eine Strommesseinrichtung 130, nachfolgend auch erste Strommesseinrichtung genannt, mit ihrem ersten Messanschluss 131 angeschlossen. Ein zweiter Messanschluss 132 der Strommesseinrichtung 130 liegt auf Erdpotential.

Entlang der Fluidstromrichtung FLS hinter der Anschlussstelle 103 sind die elektrischen Kontaktstellen E1, E2 und E3 an die Fluidleitung 100 angeschlossen, so dass diese bei einem Einspeisen des leitfähigen Fluids nacheinander mit dem leitenden Fluid benetzt werden, und zwar beginnend mit der in Fluidstromrichtung FLS ersten Kontaktstelle E1.

An einer weiteren Anschlussstelle 104 ist eine weitere Strommesseinrichtung 140, nachfolgend auch zweite Strommesseinrichtung genannt, mit ihrem ersten Messanschluss 141 angeschlossen. Ein zweiter Messanschluss 142 der weiteren Strommesseinrichtung 140 ist mit dem Erdpotential verbunden.

Eine Steuereinrichtung 150 der Erdungseinrichtung 30 überwacht und steuert die Injektionseinrichtung 110, beispielsweise anhand der Strommesswerte I01 und I02 der beiden Strommesseinrichtungen 130 und 140. Wird von der Injektionseinrichtung 110 beispielsweise eine die Leitfähigkeit erhöhende Substanz injiziert, so kann die Steuereinrichtung 150 beispielsweise den Injektionsgrad anhand der Strommesswerte der ersten Strommesseinrichtung 100 einstellen.

Zum Erden der elektrischen Kontaktstellen E1, E2 und E3 der elektrischen Einrichtung 20 wird die Anordnung 10 vorzugsweise wie folgt betrieben:

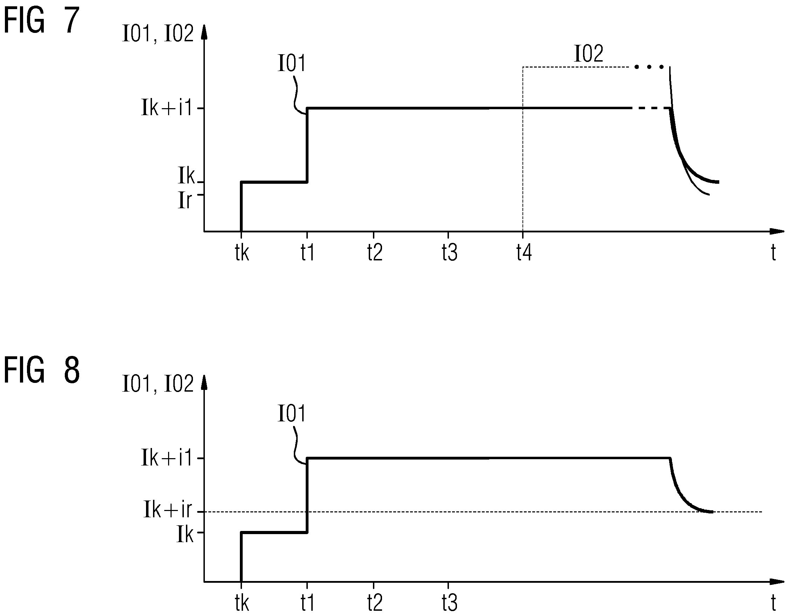

Mit der Injektionseinrichtung 110 wird an der Ausgangsstelle 101 zum Zeitpunkt t0 (siehe Figur 7) ein leitfähiges Fluid in die Fluidleitung 100 eingespeist, das von der Ausgangsstelle 101 entlang der Fluidstromrichtung FLS in Richtung zur Anregestelle 102 und von dort zur Anschlussstelle 103 fließt. Sobald das Fluid die Anschlussstelle 103 benetzt hat, wird ein elektrischer Strom zwischen dem durch die Anregestelle 102 und der Anschlussstelle 103 gebildeten Messabschnitt der Fluidleitung 100 fließen. Dieser Strom Ik wird von der ersten Strommesseinrichtung 130 gemessen.

Der Verlauf des von der Strommesseinrichtung 130 gemessenen Stroms I01 ist in der Figur 7 beispielhaft näher gezeigt. Es lässt sich erkennen, dass zum Zeitpunkt tk das leitfähige Fluid die Anschlussstelle 103 erreicht hat, so dass zwischen der Anregestelle 102 und der Anschlussstelle 103 ein Strom Ik fließen kann. Der elektrische Widerstand des leitfähigen Fluids zwischen der Anregestelle 102 und der Anschlussstelle 103 ist in der Figur 1 beispielhaft mit dem Bezugszeichen Rk gekennzeichnet. Der Strommesswert I01 zum Zeitpunkt tk beträgt somit:

$$I01(t=tk) = Ik = Uk/Rk.$$

Ausgehend von der Anschlussstelle 103 wird das Fluid entlang der Fluidstromrichtung FLS weiter in Richtung der ersten Kontaktstelle E1 fließen. Sobald die erste Kontaktstelle E1 in der Fluidleitung 100 zum Zeitpunkt t1 erreicht worden ist, wird durch das an der elektrischen Kontaktstelle E1 anliegende Potential bzw. durch die daran anliegende Spannung U1 ein Strom i1 über die Fluidleitung 100 in Richtung zur ersten Anschlussstelle 103 fließen. Der von der Spannung U1 in die Fluidleitung 100 eingeprägte Strom i1 berechnet sich wie folgt:

$$i1 = U1/RL0,$$

wobei RL0 den elektrischen Widerstand des leitfähigen Fluids in der Fluidleitung 100 zwischen der Anschlussstelle 103 und der Kontaktstelle E1 bezeichnet. Die Bezugszeichen i1, i2 und i3 bezeichnen die Ströme über die Kontaktstellen E1, E2 und E3.

Von der ersten Kontaktstelle E1 wird das Fluid zur nächsten Kontaktstelle E2 weiter fließen und diese zum Zeitpunkt t2 benetzen. Sobald die Kontaktstelle E2 benetzt ist, kann zwischen den beiden Kontaktstellen E1 und E2 ein Entladestrom über die Fluidleitung 100 fließen. Der Entladestrom berechnet sich dabei wie folgt:

$$Ie1(t=t2) = (U1-U2)/RL1,$$

wobei Ie1 den Entladestrom und RL1 den elektrischen Widerstand des leitfähigen Fluids in der Fluidleitung 100 zwischen den zwei Kontaktstellen E1 und E2 bezeichnet.

Nachfolgend wird das elektrisch leitfähige Fluid die dritte Kontaktstelle E3 zum Zeitpunkt t3 erreichen, so dass auch ein Entladestrom Ie2 zwischen der zweiten Kontaktstelle E2 und der dritten Kontaktstelle E3 fließen kann.

$$Ie2(t=t3) = (U2-U3)/RL2,$$

wobei Ie2 den Entladestrom und RL2 den elektrischen Widerstand des leitfähigen Fluids in der Fluidleitung 100 zwischen den zwei Kontaktstellen E2 und E3 bezeichnet.

Sobald das elektrische Fluid die weitere Anschlussstelle 104 und damit die weitere Strommesseinrichtung 140 erreicht, werden die drei Kontaktstellen E1, E2 und E3 mit Erdpotential verbunden. Der von der zweiten Strommesseinrichtung 140 gemessene Strom I02 ergibt sich durch die Spannung U3 an der dritten Kontaktstelle E3 und dem elektrischen Widerstand RLn der Fluidleitung 100 zwischen der dritten Kontaktstelle E3 und der weiteren Anschlussstelle 104, an die die weitere Strommesseinrichtung 140 angeschlossen ist.

Nachfolgend wird das elektrisch leitfähige Fluid wieder die Injektionseinrichtung 110 erreichen, wodurch die ringförmige Fluidleitung 100 einen ringförmig geschlossenen, leitfähigen Fluidkreis bildet.

Durch den Stromfluss I02 in Richtung Erdpotential sowie durch den Stromfluss zwischen den Kontaktstellen E1 und E2 und den Stromfluss zwischen den Kontaktstellen E2 und E3 der elektrischen Einrichtung 20 ergibt sich eine Erdung sowie die Entladung aller elektrischen Kontaktstellen, so dass die Ströme I01 und I02 über der Zeit t abfallen werden; dies zeigt die Figur 7.

In der Figur 7 lässt sich erkennen, dass nach Abschluss der Entladung der Strom I01 durch die erste Strommesseinrichtung 130 wieder auf einen Wert fällt von:

$$I01 = Ik = Uk/Rk$$

Der von der zweiten Strommesseinrichtung 140 gemessene Strom I02 fällt auf einen Wert von:

$$I02 = Ir = Uk/Rr$$

wobei Rr den elektrischen Widerstand des leitfähigen Fluids in der Fluidleitung 100 zwischen der weiteren Anschlussstelle 104 und der Anregestelle 102 bezeichnet.

Die Steuereinrichtung 150 der Erdungseinrichtung 30 überwacht die Strommesswerte der beiden Strommesseinrichtungen 130 und 140 und kann aus dem Zeitverlauf der Stromverläufe (vgl. Figur 7) schließen, dass bzw. wann die Kontaktstellen E1, E2 und E3 sicher geerdet sind; dies ist der Fall, sobald die Ströme I01 und I02 die Werte Ik und Ir erreicht haben.

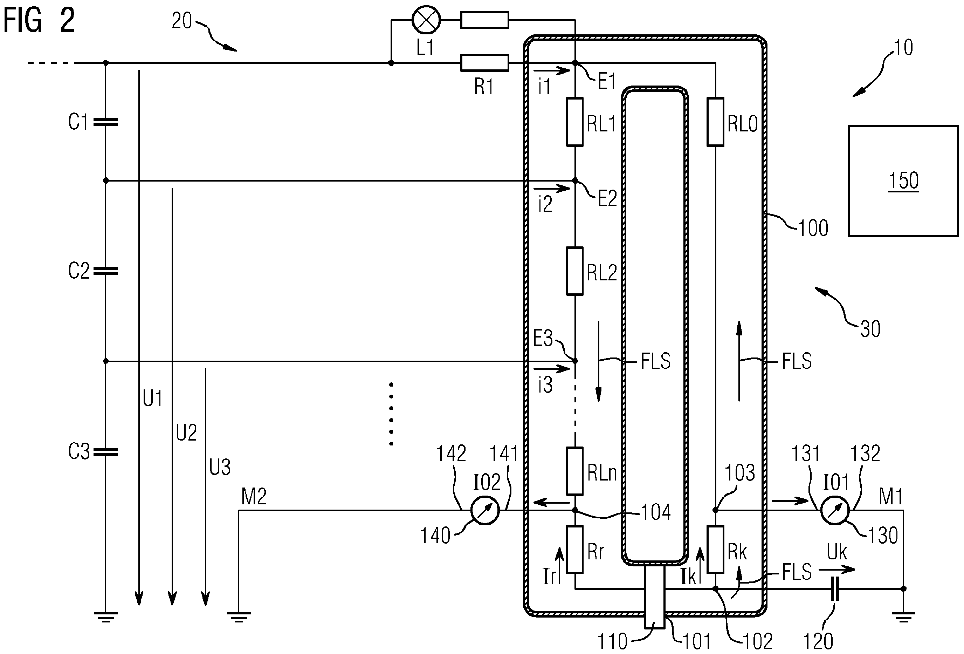

Die Figur 2 zeigt ein Ausführungsbeispiel für eine Anordnung 10, bei der die elektrische Einrichtung 20 zur Strombegrenzung der Entladungsströme bei zumindest einer Kontaktstelle, beispielsweise der ersten Kontaktstelle E1, einen Vorwiderstand R1 und ein lichtemittierendes Element L1 aufweist. Der Vorwiderstand R1 und das lichtemittierende Element L1 begrenzen den Strom i1, der über die erste Kontaktstelle E1 in die Fluidleitung 100 fließt.

Die übrigen Kontaktstellen E2 und/oder E3 können in entsprechender Weise jeweils mit einem Vorwiderstand und/oder einem lichtemittierenden Element ausgestattet sein.

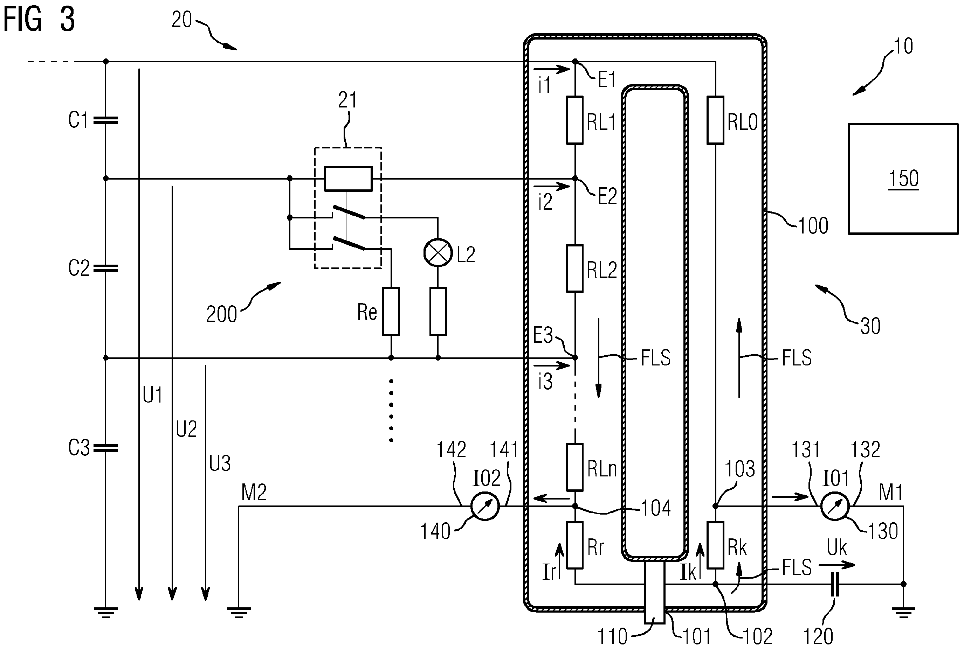

Die Figur 3 zeigt ein Ausführungsbeispiel für eine Anordnung 10, bei der die elektrische Einrichtung 20 zwischen zumindest zwei Kontaktstellen, hier der zweiten Kontaktstelle E2 und der dritten Kontaktstelle E3, eine Bypassschaltung 200 mit einem Relais 21 aufweist. Das Relais 21 verbindet - im Falle eines Stromflusses i2 über die zweite Kontaktstelle E2 - die zweite Kontaktstelle E2 mit der dritten Kontaktstelle E3 über einen Widerstand Re und/oder ein lichtemittierendes Element L2, so dass ab dem Zeitpunkt t=t2, zum dem das Fluid die zweite Kontaktstelle E2 benetzt, zwischen den beiden Kontaktstellen E2 und E3 ein Entladestrom fließen kann, und zwar noch bevor die dritte Kontaktstelle mit dem leitfähigen Fluid benetzt worden ist.

Die Bypassschaltung 200 umfasst bei dem Ausführungsbeispiel also das Relais 21, den Widerstand Re und das lichtemittierende Element L2.

Parallel zu dem direkten Entladestrom fließt ab dem Zeitpunkt t=t3, zu dem das Fluid die dritte Kontaktstelle E3 benetzt, der fluidbasierte Strom zwischen den beiden Kontaktstellen E2 und E3 über die Fluidleitung 100.

Der zu der Fluidleitung parallele Entladestrom wird also ausgelöst durch den Strom i2 über die zweite Kontaktstelle E2, also noch bevor der Strom zwischen den beiden Kontaktstellen E2 und E3 über das Fluid fließen kann.

Bei dem Ausführungsbeispiel gemäß Figur 3 ist ein Relais 21 nur zwischen der zweiten Kontaktstelle E2 und der dritten Kontaktstelle E3 vorgesehen. In entsprechender Weise können auch andere Kontaktstellen, beispielsweise die erste Kontaktstelle E1 und die zweite Kontaktstelle E2 miteinander über ein entsprechendes Relais verbunden werden.

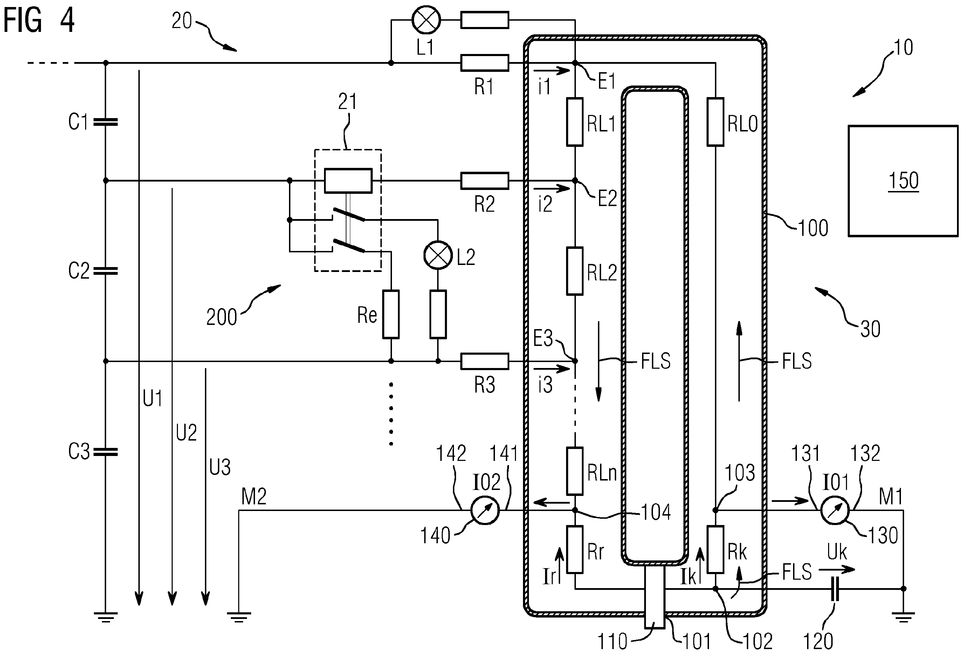

Die Figur 4 zeigt ein Ausführungsbeispiel für eine Anordnung, bei der eine oder mehrere Kontaktstellen, beispielsweise die zweite und dritte Kontaktstelle E2, E3 sowohl mit einem Relais 21 als auch mit einem Vorwiderstand R2 bzw. R3 ausgestattet sind. Die Ausführungsform gemäß Figur 4 stellt somit eine Kombination der Ausführungsvarianten gemäß den Figuren 2 und 3 dar.

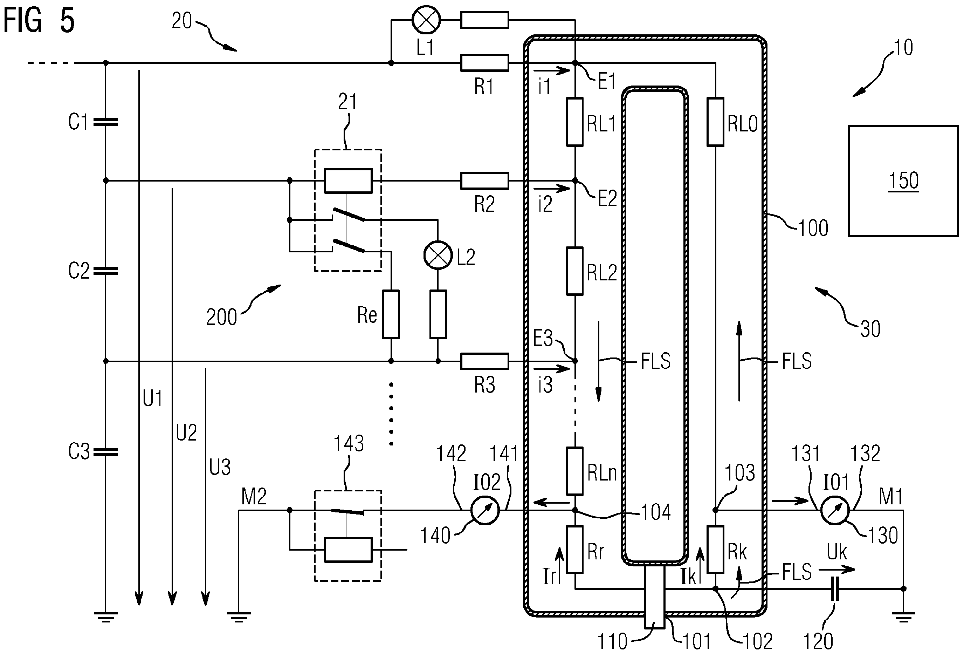

Die Figur 5 zeigt ein Ausführungsbeispiel für eine Anordnung, bei der die zweite Strommesseinrichtung 140 mit einer Schalteinrichtung 143 ausgestattet ist, die - angesteuert durch die Steuereinrichtung 150 - geöffnet werden kann und einen Stromfluss I02 über die weitere Strommesseinrichtung 140 abschalten kann.

Die Steuereinrichtung 150 wird die Schalteinrichtung 143 vorzugsweise nach Abschluss des Entladungsvorgangs abschalten, um einen Strom I02 über die weitere Strommesseinrichtung 140 zu verhindern. Diese Vorgehensweise ermöglicht es, mit der ersten Strommesseinrichtung 130 zu prüfen, ob die Fluidleitung 100 dauerhaft vollständig mit leitfähigem Fluid gefüllt ist und die Kontaktstellen E1, E2 und E3 dauerhaft sicher geerdet sind.

Nach Abschalten der weiteren Strommesseinrichtung 140 wird nämlich die gesamte Fluidleitung 100 von einem Strom durchflossen, der von der Spannungsquelle 120 eingeprägt wird. Ein erste Teilstrom wird über den Widerstand Rk, also zwischen der Anregestelle 102 und der Anschlussstelle 103, fließen. Ein zweiter Teilstrom fließt von der Anregestelle 102 über die Kontaktstellen E3, E2 und E1 zur Anschlussstelle 103 und zeigt somit eine vollständige Benetzung der Kontaktstellen E1, E2 und E3 mit dem leitfähigen Fluid an.

Der Gesamtstrom, der durch die Summe der beiden Teilströme gebildet wird und von der ersten Strommesseinrichtung 130 gemessen wird, ist dann somit größer als der Strom Ik zu Beginn des Erdungsvorgangs, da gilt:

$$I01 = Ik + Ir$$

$$I01 = Uk/Rk + Uk/(Rr+RLn+RL2+RL1+RL0)$$

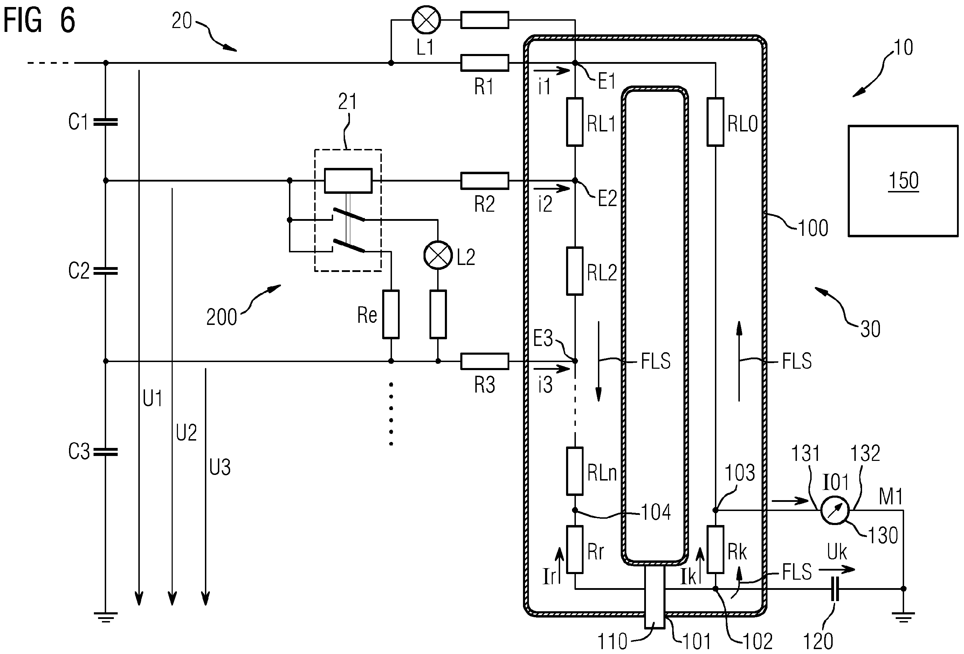

Die Figur 6 zeigt ein Ausführungsbeispiel für eine Anordnung 10, bei der die Erdungseinrichtung 30 keine weitere Stromesseinrichtung 140 aufweist. Nach Beendigung der Erdung, die anhand des Abfalls des Stroms I01 der ersten Strommesseinrichtung 130 festgestellt werden kann, kann die Steuereinrichtung 150 die komplette Füllung der Fluidleitung 100 mit leitfähigem Fluid dadurch überprüfen, dass sie den Strom I01(t<tk<t1), der in der Zeitspanne zwischen tk und t1 (vgl. Figur 8) fließt, mit dem Strom I01 am Ende des Erdungsvorgangs vergleicht. Am Ende des Erdungsvorgangs wird bei gefüllter Fluidleitung 100 ein Teilstrom Ik zwischen der Anregestelle 102 und der Anschlussstelle 103 über den Widerstand Rk sowie ein Teilstrom Ir über die Reihenschaltung der Leitungswiderstände Rk, RLn, RL2, RL1 und RL0 fließen, wie dies bei dem Ausführungsbeispiel gemäß der Figur 5 nach Abschalten der Schalteinrichtung 142 der Fall ist.

Bei den Ausführungsbeispielen gemäß den Figuren 1 bis 8 kann das leitfähige Fluid nach Abschluss des Erdens mit Hilfe eines Ablassventils 160 (nur in Figur 1 dargestellt) wieder abgelassen werden.

Die obigen Ausführungsbeispiele für eine Bezugspotentialverbindungseinrichtung können zum Beispiel zum Erden und Entladen von elektrischen Umrichtern eingesetzt werden, die eine Vielzahl an in Reihe geschalteten Submodulen aufweisen; jedes Submodul kann dabei eine zu entladende und/oder zu erdende Kontaktstelle bilden.

Ausführungsbeispiele der Erfindung können (müssen aber nicht) einige oder mehrere der folgenden Eigenschaften oder Vorteile aufweisen:

- Alternative für mechanisches Schalten durch sukzessive Erhöhen der Leitfähigkeit eines Fluids in verbindenden Schläuchen.
- Vermeiden von Funken und Verschleiß an mechanischen Kontakten und Komponenten.
- Keine mechanischen Teile, die gewartet bzw. regelmäßig geprüft werden müssen.
- Keine Stellenenergie für eine schaltende Mechanik auf Hochspannungsniveau bzw. kein Momenteneintrag von zentraler Stelle und Übertragung an die schaltende Mechanik auf Hochspannungsniveau.
- Nachweis der Sicherheit des Erdens durch Prüfstrom.
- Serielle Verschaltung von räumlich verteilten Kontaktstellen mit mindestens einem Erdungsbezugspunkt mit Hilfe einer Fluidleitung (z. B. Schlauchschleife), durch die ein leitfähiges Fluid fließt.
- Messung der Erdungsströme an einem oder zwei Massebezugspunkten der Schleife.
- Optionales Signalisieren des unsicheren Zustands, d.h. eines noch zu hohen Erdungsstromes.
- Entladen von Energiespeichern durch fluide Überbrückung der Entladekontakte mit geeignetem Entladewiderstand (große Entladedauer) bzw. durch Ansteuern einer zusätzlichen Entladebeschaltung (kleine Entladedauer).
- Optimierte, konstruktive Voreinstellung der Erdungs- und Entladeströme durch geeignete, ggf. vorkonfektionierte Widerstände bzw. elektrische Schaltungen mit Innenwiderstand und Signalisierung.
- Vermeiden der übermäßigen Erwärmung des Fluids durch Zuschalten von parallelen Lastwiderständen. Dadurch Einsparung von Kühlung und Beschleunigung des Entlade- und Erdungsvorgangs.
- Absicherung der Erdung durch Nachweis der sicheren Verbindung durch einen Prüfstrom oder Nachweis der ausreichend hohen Leitfähigkeit des Fluids.

- Regelung der Leitfähigkeit des Fluids mit Hilfe eines einfachen oder gesteuerten Schmitt-Prädiktors und wahlweise eines Luenberger-Beobachters.
- Ablaufsteuerung des Erdungs- bzw. Entladevorgangs.
- Bereitstellen eines nicht leitfähigen Fluids, dem durch Injektion eines dissoziierenden Stoffes eine Leitfähigkeit verliehen werden kann. Das Fluid sollte eine möglichst hohe Wärmekapazität aufweisen, um die Verlustwärme des Stromflusses im Fluid aufnehmen zu können, und temperaturstabil sein. Optional kann auch ein Fluid mit einer geeigneten Grundleitfähigkeit verwendet werden, die durch Injektion auf einen höheren Wert erhöht bzw. durch beimischen von Ausgangsfluid wieder vermindert werden kann.
- Öffnen eines Ventils (z. B. Bestandteil der Injektionseinrichtung 110 gemäß den Figuren 1 bis 6) für die Fluidzufuhr und Aktivieren einer Pumpe (z. B. Bestandteil der Injektionseinrichtung 110 gemäß den Figuren 1 bis 6) für das Befüllen der Schlauchschleife mit dem Fluid. Die Schleife verfügt z. B. über einen Windkessel und ein Entlüftungs- sowie ein Überdruckventil, außerdem z. B. über ein Entleerungsventil.
- Aktivieren des Erdung- und Entladeprozesses zu einem Zeitpunkt $t0$ durch Erhöhen des Stromsollwerts der Leitfähigkeitsregelung auf den gewünschten kleinen Wert des Kalibrierstromes $Ik$. Ein zugehöriger Regler (z. B. Bestandteil der Injektionseinrichtung 110 gemäß den Figuren 1 bis 6) aktiviert die Injektion des dissoziierenden Stoffes zur Leitfähigkeitserhöhung.
- Bedingt durch die Strömungsgeschwindigkeit der Flüssigkeit wird erst nach einer Totzeit, d.h. zum Zeitpunkt $tk$, am ersten Massenbezugspunkt $M1$ ein anfänglicher Strom $I01=Ik$ durch das Medium gemessen. Der Strom ist die Folge einer Kleinspannung $Uk$ von z.B. 48V, die an der Pumpe am Beginn dieses Kalibrierabschnitts aufgebracht wird.
- Die Leitfähigkeit steigt durch Regelung bis zum Zeitpunkt $tk$ auf den gewünschten Wert $I01=Ik$ an, noch bevor die leitende Fluidsäule (z. B. Wassersäule) die erste Kontaktstelle $E1$ erreicht. Das Fluid im Rohrabschnitt zwischen Pumpe und Massebezugspunkt hat den elektrischen Leitungswiderstand $Rk$.
- Zum Zeitpunkt $t1$ erreicht die leitfähige Fluidsäule die erste Kontaktstelle $E1$, so dass der Strom $i01$ am Bezugspunkt $M1$ sprunghaft um den Erdungsstrom $i1$ der ersten Kontaktstelle auf einen deutlich größeren Wert ansteigt. Hierzu wird der strombegrenzende Widerstand $R1$ an der ersten Kontaktstelle $E1$ unter Kenntnis der Schlauchlängen des Kalibrierabschnitts sowie vom Massebezugspunkt $M1$ zur ersten Kontaktstelle $E1$ vorzugsweise angemessen ausgelegt (repräsentiert in den Figuren durch die Widerstandswerte $Rk$ und $RL0$ der Kalibrierleitung und der Zuleitung). Die Leitfähigkeitsregelung wird deaktiviert, erhält die Dosierung jedoch in gleichem Maße aufrecht.
- Dem Strombegrenzungswiderstand $R1$ liegt optional eine Leuchtdiode $L1$ mit Beschaltung parallel, um den Entladevorgang anzuzeigen (vgl. z. B. Figur 2). Der Widerstand kann das mechanische Bindeglied zwischen Schlauchhülse und Kontaktstelle sein. Er kann in diskreten Schritten vorkonfektioniert vorgehalten werden.
- Als Strombegrenzungswiderstand kann auch die ohmsche Last eines Relais 21 verwendet bzw. ergänzt werden, das einen zusätzlichen Entladewiderstand $Re$ parallel zur Schlauchverbindung $RL2$ zur benachbarten Kontaktstelle aktiv schaltet. Hierdurch wird die vergleichsweise hochohmige Schlauchverbindung mit Fluid $RL2$ um einen niederohmigen Leistungswiderstand $Re$ ergänzt, um den Entladevorgang zwischen den beiden Kontaktstellen zu beschleunigen und die entstehende Wärme nicht in das Fluid einzutragen. Optional kann diesem Relais 21 zum Schutz eine zusätzliche Elektronik zur Strombegrenzung in Reihe geschaltet werden.
- Mit Weiterfließen der leitfähigen Fluidsäule werden sukzessive alle Kontaktstellen mit leitfähigem Fluid benetzt.
- Bei Erreichen der leitfähigen Fluidsäule des zweiten Massebezugspunkt $M2$ zum Zeitpunkt $t4$ wird eine zweite Verbindung zum Bezugspotential hergestellt.
- Bei Erreichen der leitfähigen Fluidsäule am Punkt der Injektion kann sich ein Stromrückfluss $Ir$ vom Beginn des Kalibrierabschnitts in Richtung des zweiten Bezugspunkts $M2$ ergeben. Die Schlauchschleife ist nun vollständig mit leitfähigem Medium gefüllt und es fließen die Erdungsströme, der Kalibrierstrom $Ik$ und ein Rückstrom $Ir$ über die beiden Bezugspunkte $M1$ und $M2$ ab.
- Hat der Summenstrom $Ik+Ir$ ein erlaubtes Maximum noch nicht erreicht, kann die Leitfähigkeitsregelung wieder aktiviert und dabei der Stromsollwert zur Erhöhung der Leitfähigkeit unter Einbeziehung der Totzeit des Gesamtsystems dynamisch bis zu einem Maximalwert erhöht werden. Die Entladung und Erdung werden beschleunigt.
- Ein Kühlaggregat (z. B. Bestandteil der Injektionseinrichtung 110 gemäß den Figuren 1 bis 6) kann für die Kühlung des leitfähigen Fluids sorgen, das sich in Folge des Stromflusses erwärmt. Die Temperatur wird vorzugsweise in der Nähe der Pumpe (z. B. Bestandteil der Injektionseinrichtung 110 gemäß den Figuren 1 bis 6) gemessen und für die Steuerung des Kühlaggregats verwendet und es wird damit ggf. Einfluss auf den Stromsollwert genommen, um den Leitwert des Fluids günstig im Sinne einer geringeren Erwärmung zu beeinflussen.
- Durch Beimischung von Reinfluid kann die Leitfähigkeit reduziert, d.h. Stellsignale zur Verminderung des Leitwerts umgesetzt werden, wenn dies z.B. in Folge der Erwärmung des Fluids notwendig ist. Die Beimischung wirkt zusätzlich kühlend. Überschüssiges Mischfluid fließt über das Überdruck- oder besser das entsprechend angesteuerte Entlastungsventil (z. B. das Ablassventil 160) ab (z. B. Öffnen bei negativem Stellsignal bei geringem hydrostatischen Gegendruck).
- Die Regelung kann durch eine reine Steuerung mit zwei Injektionsgraden ersetzt werden. Hierdurch verlängert sich die Entlade- und Erdungsgesamtzeit wegen suboptimaler Leitfähigkeit und in der Folge reduzierter Erdungsströme.

- Nach Entladen der Kontaktstellen reduziert sich der Summenstrom auf Ik+Ir, d.h. I01=Ik und I02=Ir. Bei Auftrennen der Verbindung zwischen zweitem Bezugspunkt M2 und seiner Erde mit Hilfe des Relais 142 fließt Ik über den Kalibrierabschnitt Rk sowie ein verminderter Rückstrom Ir über die Reihenschaltung der Kontaktstellen zum Bezugspunkt M1. Der Summenstrom reduziert sich zu I01=Ir+Ik, verbleibt aber größer als Ik. Hiermit wird die sichere Verbindung aller Kontaktstellen mit der Bezugserde nachgewiesen.

- Auf M2 und die weitere Strommesseinrichtung 140 kann optional verzichtet werden. In der Folge verlängert sich die Entlade- und Erdungsgesamtzeit wegen reduzierter Erdungsströme.

- Durch ein Ventil kann der Kalibrierabschnitt zwischen der Anregestelle 102 und der Anschlussstelle 103 unterbrochen bzw. mit einem Bypass verjüngt werden, so dass über diesen Weg nicht nur weniger Fluid sondern auch kein bzw. ein verringerter elektrischer Strom Ik fließt. Es verbleibt jedoch der verminderte Rückstrom Ir in gleicher Höhe. Die Bewertung dieses Stromes Ir im Vergleich zum verringerten Strom Ik wird genauer. Die Einflussnahme auf Leitwert und Temperatur des Fluids ist jetzt reduziert wird und ggf. in der Regelung adaptiv berücksichtigt. Der Umstand ist unkritisch, weil in diesem Betriebsfall keine großen Erdungsströme mehr fliesen.

- Durch Erhöhen des Stromsollwerts kann die Leitfähigkeit bis zu ihrem Maximalwert erhöht werden, um mit einem dadurch vergrößerten Rückstrom den Sicherheitsnachweis noch einfacher zu führen.

- Durch gesteuertes Öffnen des Entlastungsventils und einblasen eines Inertgases wird nach dem Erden vorzugsweise das Rohrsystem entleert und getrocknet. Das Fluid kann für eine spätere Verwendung nach Verdünnung aufgefangen oder entsorgt werden.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Bezugszeichenliste

| | |
|---|---|
| 10 | Anordnung |
| 20 | Einrichtung |
| 21 | Relais |
| 30 | Erdungseinrichtung |
| 100 | Fluidleitung |
| 101 | Ausgangsstelle |
| 102 | Anregestelle |
| 103 | Anschlussstelle |
| 104 | Anschlussstelle |
| 110 | Injektionseinrichtung |
| 120 | Spannungsquelle |
| 130 | Strommesseinrichtung |
| 131 | Messanschluss |
| 132 | Messanschluss |
| 140 | Strommesseinrichtung |
| 141 | Messanschluss |
| 142 | Schalteinrichtung |
| 150 | Steuereinrichtung |
| 200 | Bypassschaltung |
| C1 | Kondensator |
| C2 | Kondensator |
| C3 | Kondensator |
| E1 | Kontaktstelle |
| E2 | Kontaktstelle |
| E3 | Kontaktstelle |
| FLS | Fluidstromrichtung |
| Ik | Strom |
| Ir | Strom |
| I01 | Strom |
| I02 | Strom |

| | |
|---|---|
| i1 | Strom |
| i2 | Strom |
| i3 | Strom |
| L1 | lichtemittierendes Element |
| L2 | lichtemittierendes Element |
| Re | Widerstand |
| RL0 | Widerstand |
| RL1 | Widerstand |
| R12 | Widerstand |
| Rk | Widerstand |
| RLn | Widerstand |
| R1 | Vorwiderstand |
| R2 | Vorwiderstand |
| R3 | Vorwiderstand |
| tk | Zeitpunkt |
| t1 | Zeitpunkt |
| t2 | Zeitpunkt |
| t3 | Zeitpunkt |
| t4 | Zeitpunkt |
| Uk | Messspannung |
| U1 | Spannung |
| U2 | Spannung |
| U3 | Spannung |

**Patentansprüche**

1. Anordnung (10) mit einer elektrischen Einrichtung (20), die mindestens zwei elektrische Kontaktstellen (E1, E2, E3) aufweist, und einer fluidbasierten Bezugspotentialverbindungseinrichtung (30), die geeignet ist, die elektrischen Kontaktstellen (E1, E2, E3) mit einem Bezugspotential zu verbinden,
**dadurch gekennzeichnet, dass**

   - die fluidbasierte Bezugspotentialverbindungseinrichtung (30) eine ringförmige Fluidleitung (100) aufweist, die die Kontaktstellen (E1, E2, E3) in Reihe verbindet, und
   - im Falle eines Fluidstromes durch die Fluidleitung (100) das Fluid die Kontaktstellen (E1, E2, E3) ausgehend von einer Ausgangsstelle (101) Kontaktstelle (E1, E2, E3) für Kontaktstelle (E1, E2, E3) entlang einer vorgegebenen Fließrichtung nacheinander benetzt.

2. Anordnung (10) nach Anspruch 1,
**dadurch gekennzeichnet, dass** die Bezugspotentialverbindungseinrichtung (30) eine Injektionseinrichtung (110) aufweist, die an einer Injektionsstelle an die Fluidleitung (100) angeschlossen und geeignet ist, leitfähiges Fluid an der Injektionsstelle in die Fluidleitung (100) einzuspeisen und/oder die Leitfähigkeit eines in der Fluidleitung (100) befindlichen Fluids durch Einspeisen einer die Leitfähigkeit erhöhenden Substanz zu erhöhen.

3. Anordnung (10) nach einem der voranstehenden Ansprüche,
**dadurch gekennzeichnet, dass** die elektrische Einrichtung (20) bei zumindest einer der Kontaktstellen (E1, E2, E3) einen Vorwiderstand (R1, R2, R3) und/oder ein lichtemittierendes Element (L1) aufweist, der oder das bei einem Stromfluss über die Kontaktstellen (E1, E2, E3) von dem Strom (i1, i2, i3) durchflossen wird.

4. Anordnung (10) nach einem der voranstehenden Ansprüche,
**dadurch gekennzeichnet, dass** die elektrische Einrichtung (20) bei zumindest einer der Kontaktstellen (E1, E2, E3) eine Bypassschaltung (200) aufweist, die bei einem Stromfluss (i1, i2, i3) über die Kontaktstelle (E1, E2, E3) eine leitende Verbindung zu einer anderen Kontaktstelle (E1, E2, E3), insbesondere der örtlich und/oder potentialmäßig nächstliegenden Kontaktstelle (E1, E2, E3), herstellt.

5. Anordnung (10) nach einem der voranstehenden Ansprüche,
**dadurch gekennzeichnet, dass** die Fluidleitung (100) in Fluidstromrichtung (FLS) gesehen hinter der Injektionsstelle und vor der ersten Kontaktstelle (E1) einen Messabschnitt aufweist, dessen elektrische Leitfähigkeit überwacht wird.

**6.** Anordnung (10) nach einem der voranstehenden Ansprüche, **dadurch gekennzeichnet, dass**

- an die Fluidleitung (100) an einer Anschlussstelle (103), die in Fluidstromrichtung (FLS) hinter der Injektionsstelle und vor der ersten Kontaktstelle (E1) liegt, eine Strommesseinrichtung (130) angeschlossen ist, die mit einem ersten Messanschluss (131) an die Anschlussstelle (103) angeschlossen ist und mit einem zweiten Messanschluss (132) auf Bezugspotential liegt, und
- an einer Anregestelle (102), die zwischen der Injektionsstelle und der Anschlussstelle (103) der Strommesseinrichtung (130) liegt, eine Strom- oder Spannungsquelle (120) angeschlossen ist, die einen Stromfluss zwischen Anregestelle (102) und Anschlussstelle (103) hervorruft, sobald der Leitungsabschnitt der Fluidleitung (100) zwischen der Anregestelle (102) und Anschlussstelle (103) mit leitfähigem Fluid gefüllt ist.

**7.** Anordnung (10) nach Anspruch 6, **dadurch gekennzeichnet, dass** an die Strommesseinrichtung (130) eine Steuereinrichtung (150) angeschlossen ist, die die Strommesswerte der Strommesseinrichtung (130) überwacht und die Injektionseinrichtung (110) ansteuert.

**8.** Anordnung (10) nach einem der voranstehenden Ansprüche, **dadurch gekennzeichnet, dass**

- an die Fluidleitung (100) an einer weiteren Anschlussstelle (104), die in Fluidstromrichtung (FLS) hinter der letzten Kontaktstelle (E3) und vor der Injektionsstelle liegt, eine weitere Strommesseinrichtung (140) angeschlossen ist, die mit einem ersten Messanschluss (141) an die weitere Anschlussstelle (104) angeschlossen ist und mit einem zweiten Messanschluss (142) auf Bezugspotential liegt, und
- die weitere Strommesseinrichtung (140) einen weiteren Stromanstieg, der nach Einspeisen leitfähigen Fluids und/oder Einspeisen einer die Leitfähigkeit erhöhenden Substanz und nach Erreichen der weiteren Anschlussstelle (104) durch das leitfähige Fluid auftritt, erfasst.

**9.** Anordnung (10) nach Anspruch 8, **dadurch gekennzeichnet, dass**

- die Steuereinrichtung (150) mit der weiteren Strommesseinrichtung (140) verbunden ist und anhand des erfassten weiteren Stromanstiegs darauf schließt, dass die Fluidleitung (100) bis einschließlich der letzten Kontaktstelle (E3) mit leitfähigen Fluid gefüllt ist.

**10.** Anordnung (10) nach einem der voranstehenden Ansprüche, **dadurch gekennzeichnet, dass**

- zwischen der weiteren Anschlussstelle (104) und Bezugspotential eine Schalteinrichtung (143) angeordnet ist, die einen Stromfluss zwischen der weiteren Anschlussstelle (104) und Bezugspotential unterbrechen kann,
- die Steuereinrichtung (150) nach Abschluss des Ausgleichsvorganges, insbesondere Erdungsvorgangs, oder nach Absinken des Stromes durch die erste und/oder zweite Strommesseinrichtung (130, 140) die Schalteinrichtung (143) abschaltet und einen Stromfluss durch die zweite Strommesseinrichtung (140) zum Bezugspotential unterbindet und
- die Steuereinrichtung (150) den Strommesswert vor dem Erreichen der ersten Kontaktstelle (E1) durch das Fluid mit dem Strommesswert nach Abschalten der Schalteinrichtung (143) vergleicht und auf einen geschlossenen leitfähigen Fluidkreislauf schließt, wenn der Strommesswert vor dem Erreichen der ersten Kontaktstelle (E1) durch das Fluid kleiner als der Strommesswert nach Abschalten der Schalteinrichtung (143) ist.

**11.** Anordnung (10) nach einem der voranstehenden Ansprüche, **dadurch gekennzeichnet, dass** die Bezugspotentialverbindungseinrichtung (30) ein Ablassventil (160) aufweist, das ein Ablassen des in der Fluidleitung (100) befindlichen Fluids ermöglicht.

**12.** Anordnung (10) nach einem der voranstehenden Ansprüche, **dadurch gekennzeichnet, dass**

- das Bezugspotential das Erdpotential ist und

- die Bezugspotentialverbindungseinrichtung (30) eine Erdungseinrichtung ist.

13. Verfahren zum Verbinden einer elektrischen Einrichtung (20), die mindestens zwei elektrische Kontaktstellen (E1, E2, E3) aufweist, mit einem Bezugspotential mittels einer fluidbasierten Bezugspotentialverbindungseinrichtung (30), **dadurch gekennzeichnet, dass**

- die fluidbasierte Bezugspotentialverbindungseinrichtung (30) eine ringförmige Fluidleitung (100) aufweist, die die Kontaktstellen (E1, E2, E3) in Reihe verbindet, und
- die ringförmige Fluidleitung (100) unter Bildung eines leitfähigen Fluidrings mit leitfähigem Fluid gefüllt und/oder die Leitfähigkeit eines in der Fluidleitung (100) befindlichen Fluids durch Einspeisen einer die Leitfähigkeit erhöhenden Substanz erhöht wird und die Kontaktstellen (E1, E2, E3) nacheinander mit dem leitfähigem Fluid benetzt und dadurch nacheinander elektrisch miteinander verbunden werden.

14. Verfahren nach Anspruch 13, **dadurch gekennzeichnet, dass**

- die elektrische Einrichtung (20) bei zumindest einer der Kontaktstellen (E1, E2, E3) einen Vorwiderstand (R1, R2, R3) und/oder ein lichtemittierendes Element (L1) aufweist und der Stromfluss über die Kontaktstelle (E1, E2, E3) in das leitfähige Fluid durch den Vorwiderstand und/oder das lichtemittierende Element begrenzt wird, und/oder
- die elektrische Einrichtung (20) bei zumindest einer der Kontaktstellen (E1, E2, E3) eine Bypassschaltung (200) aufweist, die bei einem Stromfluss über die Kontaktstelle (E1, E2, E3) eine leitende Verbindung zu einer anderen Kontaktstelle (E1, E2, E3), insbesondere der örtlich und/oder potentialmäßig nächstliegenden Kontaktstelle (E1, E2, E3), herstellt und eine unmittelbare Entladung zwischen den miteinander verbundenen Kontaktstellen (E1, E2, E3) durchgeführt wird, und/oder
- die Fluidleitung (100) in Fluidstromrichtung (FLS) hinter der Injektionsstelle und - in Fließrichtung gesehen - vor der ersten Kontaktstelle (E1) einen Messabschnitt aufweist und die elektrische Leitfähigkeit des Messabschnitts überwacht wird und/oder
- an die Fluidleitung (100) an einer Anschlussstelle (103), die in Fluidstromrichtung (FLS) hinter der Injektionsstelle und vor der ersten Kontaktstelle (E1) liegt, an die Fluidleitung (100) eine Strommesseinrichtung (130) angeschlossen ist, die mit einem ersten Messanschluss (131) an die Anschlussstelle (103) angeschlossen ist und mit einem zweiten Messanschluss (132) auf Bezugspotential liegt, und an einer Anregestelle (102), die zwischen der Injektionsstelle und der Anschlussstelle (103) der Strommesseinrichtung (130) liegt, eine Strom- oder Spannungsquelle (120) angeschlossen ist, die einen Stromfluss zwischen Anregestelle (102) und Anschlussstelle (103) hervorruft, sobald der Leitungsabschnitt der Fluidleitung (100) zwischen der Anregestelle (102) und der Anschlussstelle (103) mit leitfähigem Fluid gefüllt ist, die Strommesswerte der Strommesseinrichtung (130) überwacht werden und die Injektionseinrichtung (110) anhand der Strommesswerte angesteuert wird, und/oder
- mit der Strommesseinrichtung (130) ein Stromanstieg, der nach Einspeisen leitfähigen Fluids und/oder Einspeisen einer die Leitfähigkeit erhöhenden Substanz und nach Erreichen der ersten Kontaktstelle (E1) durch das leitfähige Fluid auftritt, erfasst wird und anhand des Stromanstiegs darauf geschlossen wird, dass die Fluidleitung (100) bis zur ersten Anschlussstelle (103) mit leitfähigem Fluid gefüllt ist, und/oder
- mit der Strommesseinrichtung (130) ein weiterer Stromanstieg, der nach Erreichen der ersten Kontaktstelle (E1, E2, E3) durch das leitfähige Fluid auftritt, erfasst wird und anhand des weiteren Stromanstiegs darauf geschlossen wird, dass die Fluidleitung (100) bis zu der ersten Kontaktstelle (E1) mit dem leitfähigen Fluid gefüllt ist und/oder
- an die Fluidleitung (100) an einer weiteren Anschlussstelle (104), die in Fluidstromrichtung (FLS) hinter der letzten Kontaktstelle (E3) und vor der Injektionsstelle liegt, eine weitere Strommesseinrichtung (140) angeschlossen ist, die mit einem ersten Messanschluss (141) an die weitere Anschlussstelle (104) angeschlossen ist und mit einem zweiten Messanschluss (142) auf Bezugspotential liegt, und die weiteren Strommesswerte der weiteren Strommesseinrichtung (140) überwacht werden und/oder
- ein von der weiteren Strommesseinrichtung (140) gemessener Stromanstieg, der nach Einspeisen des leitfähigen Fluid und/oder Einspeisen der die Leitfähigkeit erhöhenden Substanz und Erreichen der weiteren Anschlussstelle (104) durch das leitfähige Fluid auftritt, erfasst wird und anhand dieses Stromanstiegs darauf geschlossen wird, dass die Fluidleitung (100) bis einschließlich der letzten Kontaktstelle (E3) mit leitfähigen Fluid gefüllt ist und/oder
- zwischen der weiteren Anschlussstelle (104) und Bezugspotential eine Schalteinrichtung (143) angeordnet ist, die einen Stromfluss zwischen der weiteren Anschlussstelle (104) und Bezugspotential unterbrechen kann, und nach Abschluss des Erdungsvorganges oder nach Absinken des durch die erste und/oder zweite Strommesseinrichtung (130, 140) fließenden Stromes die Schalteinrichtung (143) abgeschaltet wird und ein Stromfluss durch die zweite Strommesseinrichtung (140) zur Bezugspotential unterbunden wird und/oder
- der Strommesswert der ersten Strommesseinrichtung (130) vor dem Erreichen der ersten Kontaktstelle (E1) durch das Fluid mit dem Strommesswert der ersten Strommesseinrichtung (130) nach Abschalten der Schalteinrichtung (143) verglichen wird und auf einen geschlossenen leitfähigen Fluidkreislauf geschlossen wird, wenn der Strommesswert der ersten Strommesseinrichtung (130) vor dem Erreichen der ersten Kontaktstelle (E1) durch das Fluid kleiner als der Strommesswert der ersten Strommesseinrichtung (130) nach Abschalten der Schalteinrichtung (143) ist.

**Claims**

1. Arrangement (10) having an electrical device (20), which has at least two electrical contact points (E1, E2, E3), and having a fluid-based reference potential connecting device (30) which is suitable for connecting the electrical contact points (E1, E2, E3) to a reference potential,
   **characterized in that**

   - the fluid-based reference potential connecting device (30) has an annular fluid line (100) which connects the contact points (E1, E2, E3) in series, and
   - if a fluid flows through the fluid line (100), the fluid successively wets the contact points (E1, E2, E3), starting from a starting point (101), contact point (E1, E2, E3) by contact point (E1, E2, E3), along a predefined flow direction.

2. Arrangement (10) according to Claim 1,
   **characterized in that**
   the reference potential connecting device (30) has an injection device (110) which is connected to the fluid line (100) at an injection point and is suitable for feeding conductive fluid into the fluid line (100) at the injection point and/or for increasing the conductivity of a fluid in the fluid line (100) by feeding in a substance which increases the conductivity.

3. Arrangement (10) according to one of the preceding claims,
   **characterized in that**
   the electrical device (20) has, at at least one of the contact points (E1, E2, E3), a series resistor (R1, R2, R3) and/or a light-emitting element (L1), through which the current (i1, i2, i3) flows if current flows via the contact points (E1, E2, E3).

4. Arrangement (10) according to one of the preceding claims,
   **characterized in that**
   the electrical device (20) has, at at least one of the contact points (E1, E2, E3), a bypass circuit (200) which, if current (i1, i2, i3) flows via the contact point (E1, E2, E3), establishes a conductive connection to another contact point (E1, E2, E3), in particular the contact point (E1, E2, E3) which is closest in terms of location and/or potential.

5. Arrangement (10) according to one of the preceding claims,
   **characterized in that**
   the fluid line (100) has, downstream of the injection point and upstream of the first contact point (E1) as seen in the fluid flow direction (FLS), a measuring section whose electrical conductivity is monitored.

6. Arrangement (10) according to one of the preceding claims,
   **characterized in that**

   - a current measuring device (130) is connected to the fluid line (100) at a connection point (103) which is downstream of the injection point and upstream of the first contact point (E1) in the fluid flow direction (FLS), a first measuring connection (131) of which current measuring device is connected to the connection point (103) and a second measuring connection (132) of which current measuring device is at reference potential, and
   - a current or voltage source (120) is connected at an excitation point (102) which is between the injection point and the connection point (103) of the current measuring device (130), which current or voltage source causes a current flow between the excitation point (102) and the connection point (103) as soon as the line section of the fluid line (100) between the excitation point (102) and the connection point (103) has been filled with conductive fluid.

7. Arrangement (10) according to Claim 6,
   **characterized in that**
   a control device (150) is connected to the current measuring device (130), which control device monitors the measured current values from the current measuring device (130) and controls the injection device (110).

8. Arrangement (10) according to one of the preceding claims,
   **characterized in that**

   - a further current measuring device (140) is connected to the fluid line (100) at a further connection point (104) which is downstream of the last contact point (E3) and upstream of the injection point in the fluid flow direction (FLS), a first measuring connection (141) of which further current measuring device is connected to the further connection point (104) and a second measuring connection (142) of which further current measuring device is at reference potential, and
   - the further current measuring device (140) captures a further current rise which occurs after conductive fluid has been fed in and/or after a substance increasing the conductivity has been fed in and after the further connection point (104) has been reached by the conductive fluid.

9. Arrangement (10) according to Claim 8,
   **characterized in that**

   - the control device (150) is connected to the further current measuring device (140) and, on the basis of the captured further current rise, concludes that the fluid line (100), up to and including the last contact point (E3), has been filled with conductive fluid.

10. Arrangement (10) according to one of the preceding claims,
    **characterized in that**

    - a switching device (143) is arranged between the further connection point (104) and the reference potential and can interrupt a current flow between the further connection point (104) and the reference potential,
    - the control device (150) disconnects the switching device (143) after the adjustment operation, in particular the grounding operation, has been concluded or after the current through the first and/or second current measuring device (130, 140) has fallen and prevents a current flow through the second current measuring device (140) to the reference potential, and
    - the control device (150) compares the measured current value before the first contact point (E1) is reached by the fluid with the measured current value after the switching device (143) has been disconnected and infers a closed conductive fluid circuit if the measured current value before the first contact point (E1) is reached by the fluid is lower than the measured current value after the switching device (143) has been disconnected.

11. Arrangement (10) according to one of the preceding claims,
    **characterized in that**
    the reference potential connecting device (30) has a drain valve (160) which makes it possible to drain the fluid in the fluid line (100).

12. Arrangement (10) according to one of the preceding claims,
    **characterized in that**

    - the reference potential is the ground potential, and
    - the reference potential connecting device (30) is a grounding device.

13. Method for connecting an electrical device (20), which has at least two electrical contact points (E1, E2, E3), to a reference potential by means of a fluid-based reference potential connecting device (30),
    **characterized in that**

    - the fluid-based reference potential connecting device (30) has an annular fluid line (100) which connects the contact points (E1, E2, E3) in series, and

- the annular fluid line (100) is filled with conductive fluid so as to form a conductive fluid ring, and/or the conductivity of a fluid in the fluid line (100) is increased by feeding in a substance which increases the conductivity, and the contact points (E1, E2, E3) are successively wetted with the conductive fluid and, as a result, are electrically connected to one another in succession.

14. Method according to Claim 13,
**characterized in that**

- the electrical device (20) has a series resistor (R1, R2, R3) and/or a light-emitting element (L1) at at least one of the contact points (E1, E2, E3), and the current flow via the contact point (E1, E2, E3) into the conductive fluid is limited by the series resistor and/or the light-emitting element, and/or
- the electrical device (20) has, at at least one of the contact points (E1, E2, E3), a bypass circuit (200) which, if a current flows via the contact point (E1, E2, E3), establishes a conductive connection to another contact point (E1, E2, E3), in particular the contact point (E1, E2, E3) which is closest in terms of location and/or potential, and an immediate discharge between the contact points (E1, E2, E3) which are connected to one another is carried out, and/or
- the fluid line (100) has a measuring section downstream of the injection point in the fluid flow direction (FLS) and

- as seen in the flow direction - upstream of the first contact point (E1), and the electrical conductivity of the measuring section is monitored, and/or

- a current measuring device (130) is connected to the fluid line (100) at a connection point (103) which is downstream of the injection point and upstream of the first contact point (E1) in the fluid flow direction (FLS), a first measuring connection (131) of which current measuring device is connected to the connection point (103) and a second measuring connection (132) of which current measuring device is at reference potential, and a current or voltage source (120) is connected at an excitation point (102) which is between the injection point and the connection point (103) of the current measuring device (130), which current or voltage source causes a current flow between the excitation point (102) and the connection point (103) as soon as the line section of the fluid line (100) between the excitation point (102) and the connection point (103) has been filled with conductive fluid, the measured current values from the current measuring device (130) are monitored, and the injection device (110) is controlled on the basis of the measured current values, and/or
- a current rise, which occurs after conductive fluid has been fed in and/or after a substance which increases the conductivity has been fed in and after the first contact point (E1) has been reached by the conductive fluid, is captured using the current measuring device (130), and it is concluded, on the basis of the current rise, that the fluid line (100) up to the first connection point (103) has been filled with conductive fluid, and/or
- a further current rise, which occurs after the first contact point (E1, E2, E3) has been reached by the conductive fluid, is captured using the current measuring device (130), and it is concluded, on the basis of the further current rise, that the fluid line (100) up to the first contact point (E1) has been filled with the conductive fluid, and/or
- a further current measuring device (140) is connected to the fluid line (100) at a further connection point (104) which is downstream of the last contact point (E3) and upstream of the injection point in the fluid flow direction (FLS), a first measuring connection (141) of which further current measuring device is connected to the further connection point (104) and a second measuring connection (142) of which further current measuring device is at reference potential, and the further measured current values from the further current measuring device (140) are monitored, and/or
- a current rise, which is measured by the further current measuring device (140) and occurs after the conductive fluid has been fed in and/or after the substance which increases the conductivity has been fed in and after the further connection point (104) has been reached by the conductive fluid, is captured, and it is concluded, on the basis of this current rise, that the fluid line (100), up to and including the last contact point (E3), has been filled with conductive fluid, and/or
- a switching device (143) is arranged between the further connection point (104) and the reference potential and can interrupt a current flow between the further connection point (104) and the reference potential, and the switching device (143) is disconnected after the grounding operation has been concluded or after the current flowing through the first and/or second current measuring device (130, 140) has fallen, and a current flow through the second current measuring device (140) to the reference potential is prevented, and/or
- the measured current value from the first current measuring device (130) before the first contact point (E1) is reached by the fluid is compared with the measured current value from the first current measuring device (130) after the switching device (143) has been disconnected, and a closed conductive fluid circuit is inferred if the measured current value from the first current measuring device (130) before the first contact point (E1) is reached by the fluid is lower than the measured current value from the first current measuring device (130) after the switching device (143) has been disconnected.

**Revendications**

1. Ensemble (10) comprenant un dispositif (20) électrique, qui a au moins deux points (E1, E2, E3) de contact électrique, et un dispositif (30) de connexion à un potentiel de référence reposant sur du fluide, qui est propre à connecter les points (E1, E2, E3) de contact électrique à un potentiel de référence,
   **caractérisé en ce que**

   - le dispositif (30) de connexion à un potentiel de référence reposant sur du fluide a un conduit (100) annulaire pour du fluide, qui monte en série les points (E1, E2, E3) de contact, et
   - dans le cas d'un courant de fluide dans le conduit (100) pour du fluide, le fluide mouille les points (E1, E2, E3) de contact à partir d'un point (101) initial, point (E1, E2, E3) de contact par point (E1, E2, E3) de contact, l'un après l'autre suivant un sens d'écoulement donné à l'avance.

2. Ensemble (10) suivant la revendication 1,
   **caractérisé en ce que**
   le dispositif (30) de connexion à un potentiel de référence a un dispositif (110) d'injection, qui est raccordé au conduit (100) pour du fluide en un point d'injection et qui est propre à injecter du fluide conducteur au point d'injection dans le conduit (100) pour du fluide et/ou à augmenter la conductivité d'un fluide se trouvant dans le conduit (100) pour du fluide par injection d'une substance augmentant la conductivité.

3. Ensemble (10) suivant l'une des revendications précédentes,
   **caractérisé en ce que**
   le dispositif (20) électrique a, pour au moins l'un des points (E1, E2, E3) de contact, une résistance (R1, R2, R3) ballast et/ou un élément (L1) émettant de la lumière qui, s'il y a un flux de courant passant par les points (E1, E2, E3) de contact, est parcouru par le courant (i1, i2, i3).

4. Ensemble (10) suivant l'une des revendications précédentes,
   **caractérisé en ce que**
   le dispositif (20) électrique a, pour au moins l'un des points (E1, E2, E3) de contact, un circuit (200) de dérivation qui, s'il passe un flux (i1, i2, i3) de courant par les points (E1, E2, E3) de contact, produit une liaison conductrice vers un autre point (E1, E2, E3) de contact, notamment vers le point (E1, E2, E3) de contact le plus proche dans l'espace et/ou en potentiel.

5. Ensemble (10) suivant l'une des revendications précédentes,
   **caractérisé en ce que**
   le conduit (100) pour du fluide a, considéré dans le sens (FLS) du courant de fluide derrière le point d'injection et avant le premier point (E1) de contact, une section de mesure, dont on contrôle la conductivité électrique.

6. Ensemble (10) suivant l'une des revendications précédentes,
   **caractérisé en ce que**,

   - au conduit (100) pour du fluide est raccordé en un point (103) de connexion, qui est dans le sens (FLS) du courant de fluide derrière le point d'injection et avant le premier point (E1) de contact, un dispositif (130) de mesure du courant, qui est raccordé au point (103) de connexion à une première borne (131) de mesure et qui est, par une deuxième borne (132) de mesure, au potentiel de référence, et
   - en un point (102) d'excitation, qui est entre le point d'injection et le point (103) de connexion du dispositif (130) de mesure du courant, est connectée une source (120) de courant ou de tension, qui provoque un flux de courant entre le point (102) d'excitation et le point (103) de connexion, dès que le tronçon du conduit (100) pour du fluide entre le point (102) d'excitation et le point (103) de connexion est empli de fluide conducteur.

7. Ensemble (10) suivant la revendication 6,
   **caractérisé en ce que**,
   au dispositif (130) de mesure du courant est connecté un dispositif (150) de commande, qui contrôle des valeurs de mesure du courant du dispositif (130) de mesure du courant et commande le dispositif (110) d'injection.

**8.** Ensemble (10) suivant l'une des revendications précédentes,
**caractérisé en ce que**,

- au conduit (100) pour du fluide est connecté en un autre point (104) de connexion, qui dans le sens (FLS) du courant de fluide est derrière le dernier point (E3) de contact et avant le point d'injection, un autre dispositif (140) de mesure du courant, qui est connecté à l'autre point (104) de mesure par une première borne (141) de mesure et qui est au potentiel de référence par une deuxième borne (142) de mesure, et
- l'autre dispositif (140) de mesure du courant détecte une autre augmentation du courant, qui se produit après l'injection de fluide conducteur et/ou l'injection d'une substance augmentant la conductivité et après que le fluide conducteur a atteint l'autre point (104) de connexion.

**9.** Ensemble (10) suivant la revendication 8,
**caractérisé en ce que**

- le dispositif (150) de commande est connecté à l'autre dispositif (140) de mesure du courant et, à l'aide de l'autre augmentation de courant qui est détectée, il est déduit que le conduit (100) pour du fluide est rempli de fluide conducteur jusqu'à y compris le dernier point (E3) de contact.

**10.** Ensemble (10) suivant l'une des revendications précédentes,
**caractérisé en ce que**

- entre l'autre point (104) de connexion et le potentiel de référence est monté un dispositif (143) de coupure, qui peut interrompre un flux de courant entre l'autre point (104) de connexion et le potentiel de référence,
- le dispositif (150) de commande, après que l'opération de compensation est terminée, notamment une opération de mise à la terre, ou après la diminution du courant dans le premier et/ou le deuxième dispositif (130, 140) de mesure du courant, ouvre le dispositif (143) de coupure et interdit un flux de courant dans le deuxième dispositif (140) de mesure vers le potentiel de référence et
- le dispositif (150) de commande compare la valeur de mesure du courant, avant que le premier point (E1) de contact soit atteint par le fluide, à la valeur de mesure du courant après l'ouverture du dispositif (143) de coupure et déduit qu'un circuit de fluide conducteur est fermé, si la valeur de mesure du courant, avant que le premier point (E1) de contact soit atteint par le fluide, est plus petite que la valeur de mesure du courant après ouverture du dispositif (143) de coupure.

**11.** Ensemble (10) suivant l'une des revendications précédentes,
**caractérisé en ce que**
le dispositif (30) de connexion à un potentiel de référence a une soupape (160) d'évacuation, qui rend possible une évacuation du fluide se trouvant dans le conduit (100) pour du fluide.

**12.** Ensemble (10) suivant l'une des revendications précédentes,
**caractérisé en ce que**

- le potentiel de référence est le potentiel de terre et
- le dispositif (30) de connexion à un potentiel de référence est un dispositif de mise à la terre.

**13.** Procédé de connexion d'un dispositif (20) électrique, qui a au moins deux points (E1, E2, E3) de contact électrique, à un potentiel de référence au moyen d'un dispositif (30) de connexion à un potentiel de référence reposant sur du fluide,
**caractérisé en ce que**

- le dispositif (30) de connexion à un potentiel de référence reposant sur du fluide a un conduit (100) annulaire pour du fluide, qui monte en série les points (E1, E2, E3) de contact, et
- on emplit le conduit (100) annulaire pour du fluide de fluide conducteur avec formation d'un anneau de fluide conducteur et/ou on augmente la conductivité d'un fluide se trouvant dans le conduit (100) pour du fluide, en injectant une substance augmentant la conductivité, et on mouille les points (E1, E2, E3) de contact l'un après l'autre par le fluide conducteur et on les connecte ainsi l'un après l'autre électriquement entre eux.

**14.** Procédé suivant la revendication 13,
**caractérisé en ce que**

- le dispositif (20) électrique a, pour au moins l'un des points (E1, E2, E3) de contact, une résistance (R1, R2, R3) de ballast et/ou un élément (L1) émettant de la lumière et on limite, par la résistance de ballast et/ou par l'élément émettant de la lumière, le flux de courant passant par les points (E1, E2, E3) de contact dans le fluide conducteur, et/ou

- le dispositif (20) électrique a, pour au moins l'un des points (E1, E2, E3) de contact, un circuit de dérivation, qui produit une liaison conductrice vers un autre point (E1, E2, E3) de contact, notamment le point (E1, E2, E3) de contact le plus proche dans l'espace et/ou en potentiel, et on effectue une décharge directe entre les points (E1, E2, E3) de contact connectés entre eux, et/ou

- le conduit (100) pour du fluide a, dans le sens (FLS) du courant de fluide derrière le point d'injection et - considéré dans le sens d'écoulement - avant le premier point (E1) de contact, une section de mesure et on contrôle la conductivité électrique de la section de mesure et/ou

- au conduit (100) pour du fluide est raccordé en un point (103) de connexion, qui est dans le sens (FLS) du courant de fluide derrière le point d'injection et avant le premier point (E1) de contact, un dispositif (130) de mesure du courant, qui est raccordé au point (103) de connexion à une première borne (131) de mesure et qui est, par une deuxième borne (132) de mesure, au potentiel de référence et, en un point (102) d'excitation, qui est entre le point d'injection et le point (103) de connexion du dispositif (130) de mesure du courant, est connectée une source (120) de courant ou de tension, qui provoque un flux de courant entre le point (102) d'excitation et le point (103) de connexion, dès que le tronçon du conduit (100) pour du fluide entre le point (102) d'excitation et le point (103) de connexion est empli de fluide conducteur, on contrôle les valeurs de mesure du courant du dispositif (130) de mesure du courant et on commande le dispositif (110) d'injection à l'aide des valeurs de mesure du courant, et/ou

- on détecte, par le dispositif (130) de mesure du courant, une augmentation du courant, qui se produit après l'injection de fluide conducteur et/ou l'injection d'une substance augmentant la conductivité et après que le fluide conducteur a atteint le premier point (E1) de contact, et, à l'aide de l'augmentation du courant, on déduit que le conduit (100) pour du fluide est empli de fluide jusqu'au premier point (103) de connexion et/ou

- par le dispositif (130) de mesure du courant, on détecte une autre augmentation du courant, qui se produit après que le fluide conducteur a atteint le premier point (E1, E2, E3) de contact et, à l'aide de l'autre augmentation du courant, on déduit que le conduit (100) pour du fluide est empli du fluide conducteur jusqu'au premier point (E1) de contact et/ou

- au conduit (100) pour du fluide est connecté, en un autre point (104) de connexion, qui dans le sens (FLS) du courant de fluide est derrière le dernier point (E3) de contact et avant le point d'injection, un autre dispositif (140) de mesure du courant, qui est connecté à l'autre point (104) de mesure par une première borne (141) de mesure et qui est au potentiel de référence par une deuxième borne (142) de mesure, et on contrôle les autres valeurs de mesure du courant de l'autre dispositif (140) de mesure du courant et/ou

- on détecte une augmentation du courant mesurée par l'autre dispositif (140) de mesure du courant, qui se produit après l'injection du fluide conducteur et/ou l'injection de la substance augmentant la conductivité et après que le fluide conducteur a atteint l'autre point (104) de connexion et, à l'aide de cette augmentation du courant, on déduit que le conduit (100) pour du fluide est empli de fluide conducteur jusqu'à y compris le dernier point (E3) de contact et/ou

- entre l'autre point (104) de connexion et le potentiel de référence est monté un dispositif (143) de coupure, qui peut interrompre un flux de courant entre l'autre point (104) de connexion et le potentiel de référence, et après que l'opération de mise à la terre est terminée ou après la diminution du courant passant dans le premier et/ou le deuxième dispositif (130, 140) de mesure du courant, on ouvre le dispositif (143) de coupure et on interdit un flux de courant dans le deuxième dispositif (140) de mesure du courant vers le potentiel de référence et/ou

- on compare la valeur de mesure du courant du premier dispositif (130) de mesure du courant, avant que le fluide ait atteint le premier point (E1) de contact, à la valeur de mesure du courant du premier dispositif (130) de mesure du courant après ouverture du dispositif (143) de coupure et on déduit qu'il y a un circuit de fluide conducteur fermé, si la valeur de mesure du courant du premier dispositif (130) de mesure du courant, avant que le fluide ait atteint le premier point (E1) de contact, est plus petite que la valeur de mesure du courant du premier dispositif (130) de mesure du courant après l'ouverture du dispositif (143) de coupure.

FIG 1

EP 3 678 457 B1

FIG 2

EP 3 678 457 B1

FIG 3

EP 3 678 457 B1

FIG 4

FIG 5

FIG 6

FIG 7

FIG 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 112007002875 B4